(19) Europäisches Patentamt
European Patent Office
Office européen des brevets

(11) **EP 4 352 462 B1**

(12) **EUROPEAN PATENT SPECIFICATION**

(45) Date of publication and mention
of the grant of the patent:
**18.06.2025 Bulletin 2025/25**

(21) Application number: **22731622.1**

(22) Date of filing: **02.06.2022**

(51) International Patent Classification (IPC):
**G01D 5/20** (2006.01)    **G01B 7/00** (2006.01)

(52) Cooperative Patent Classification (CPC):
**G01D 5/2026; G01D 5/202; H03K 17/9537;
H03K 17/972;** H03K 2017/9713

(86) International application number:
**PCT/EP2022/065008**

(87) International publication number:
**WO 2022/258474 (15.12.2022 Gazette 2022/50)**

(54) **POSITION OR MOVEMENT SENSING SYSTEM**

POSITIONS- ODER BEWEGUNGSERFASSUNGSSYSTEM

SYSTÈME DE DÉTECTION DE POSITION OU DE MOUVEMENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **08.06.2021 GB 202108161**

(43) Date of publication of application:
**17.04.2024 Bulletin 2024/16**

(73) Proprietor: **Sonuus Limited
St Neots, Cambridgeshire PE19 7AL (GB)**

(72) Inventor: **CLARK, James Hastings
Cambridgeshire PE19 7AL (GB)**

(74) Representative: **Marks & Clerk LLP
15 Fetter Lane
London EC4A 1BW (GB)**

(56) References cited:
EP-A1- 2 558 822      GB-A- 2 494 183
GB-A- 2 494 230      GB-A- 2 569 578
GB-A- 2 570 533      GB-A- 2 570 533
GB-A- 2 576 610      GB-A- 2 578 346
US-A1- 2012 062 499

**Description**

TECHNICAL FIELD OF INVENTION

The invention relates to a sensor, a system comprising a plurality of the sensors, and a method of detecting position or movement. Some embodiments detect for example velocity or movement of a key of a musical or computer keyboard.

BACKGROUND

The applicant has previously described resonant circuit-based sensors in GB2494230A, and keyboard sensor systems in GB2570533A. More generally, we refer to GB1115184.2 (publication GB2494183); GB1721448.7 (GB2569578); GB1812826.4 (publication GB2570533); GB1909213.9 (GB2576610); GB1909214.7 (GB2578346); GB2017797.8; and GB1208162.6 (GB2494230).

Resonant sensors, in particular position sensors and sensing systems, that employ an inductive coil as the sensing have many use cases due to their reliability, precision, accuracy, and low cost. However, for many applications, such sensing systems are not suitable because the electrical power required to drive the inductive coil of the sensor can be too high. For example, high power is disadvantageous in systems requiring a wireless connection and/or battery power.

Furthermore, the inductive coil is generally excited by a high-frequency drive signal, e.g. with a frequency more than 1 MHz. This drive signal is often comprised of a fundamental frequency and harmonic frequencies, which can extend to 10s or 100s of MHz, and cause radiation of unwanted electro-magnetic waves that can interfere with other systems. Consequently, resonant sensors as known in the art may be disadvantageous, or unsuitable, for any system requiring low levels of electromagnetic interference (EMI), such as a high-precision position sensor where, e.g. it is desirable to calculate velocity accurately.

To reduce unwanted electro-magnetic radiation and/or EMI, it could be considered to employ a sinusoidal drive signal containing no harmonic frequencies. However, this can add additional cost, complexity, and furthermore still doesn't address the problem of high electrical power requirements.

Electrical power requirements and unwanted electro-magnetic radiation are further increased in systems containing many resonant position sensors, in particular where such sensors are operated at the same time. For example, 88 position sensors may be required to sense the position of keys on a musical (piano) keyboard, or 104 or more position sensors may be required to sense the position of keys on a computer keyboard. It would be further advantageous to reduce power consumption in a computer keyboard, as such keyboards are often wireless for user convenience and thus require a local battery supply.

There is therefore a desire to provide a position and/or movement sensing system employing inductive sensing techniques and having, inter alia, reduced electrical power requirements, reduced EMI emissions, greater accuracy, increased sensor output reproducibility, and/or increased sensor speed for example to allow faster scan rates.

SUMMARY

According to one aspect there is provided a sensor comprising: a resonant circuit comprising a passive load and an active circuit, wherein at least one of the active circuit and passive load is tuned to resonate at a resonant frequency; a driver to drive the active circuit to output an RF signal at the resonant frequency; a drive enable circuit to generate a control signal to enable and disable the driver; a sample-and-hold circuit for an amplitude signal indicating amplitude of an RF signal output from one of the passive load or active circuit, wherein the sample-and-hold circuit is to hold a peak level of the amplitude signal, the peak level being a peak level during a period when the driver is enabled. The sensor further comprises a measurement circuit to detect a relative position and/or movement between the passive load and active circuit based on the held peak level, the detection based on measuring the held peak level when the driver is disabled by the drive enable circuit.

The active circuit and/or passive load may comprise an inductive coil incorporated into a tuned electronic circuit, wherein the tuned electronic circuit is configured to resonate with the resonant frequency $f_R$. Thus, one or both of the active circuit or passive load preferably comprises a tuned resonant circuit. One of said active circuit or passive load may be excited by a drive signal from the driver, where the driver generally outputs an RF signal with frequency equal to, or close to, $f_R$. Generally, the passive load (otherwise referred to as a target) is chosen such that proximity of said passive load element to the active circuit causes a change in state of one of said passive load or active circuit, for example by changing the frequency of resonance and/or quality factor of a tuned circuit, or by the transfer of electrical energy from the active circuit to said target/passive load. The relative position and/or movement and/or velocity (e.g. speed) of said active circuit and target may be sensed by detecting such changes, e.g. in the resonant state of a tuned circuit.

In some examples, the sample-and-hold circuit may be configured to be effectively isolated from the driver (e.g. by grounding) during a detection by the measurement circuit. For example, the sample-and-hold circuit may have a threshold voltage such that, where an input to the sample-and-hold circuit is below said threshold voltage, the peak level held by the sample-and-hold circuit is unaffected by noise and/or other signals at the input. The sample-and-hold circuit may be implemented digitally or with analogue circuits. In either case, advantageously, it is not necessary that the driver remain active/enabled in order for the measurement circuit to detect a relative position and/or movement within the sensor. In this way, the sampling circuit may hold a peak amplitude from a point in time at which the active circuit was being driven. Thus, a relative position or movement may be detected/measured indirectly, after the driver has been disabled. This may allow for a reduction in power required for the sensing. Additionally or alternatively, the system may provide for a reduction in Electromagnetic Interference (EMI), since the sensor driver need not be active during the sensing.

Generally, the measurement circuit may detect a variation of a resonant signal output by the active circuit or passive load, to determine a relative position and/or movement of the active circuit and passive load.

The control signal of the driver may be configured or timed to repeatedly and/or periodically enable and disable the driver, preferably (i.e., optionally) such that the driver does not drive the active circuit simultaneously with a measurement / detection by the measurement circuit.

In some implementations the measurement circuit may be to detect a relative velocity between the passive load and the active circuit. In this regard, a plurality of successive relative positions may be detected in order to determine/calculate a relative velocity between the active circuit and the passive load.

In implementations, the sample-and-hold circuit comprises a peak detection input circuit, the peak detection input circuit configured to perform amplitude sensitive demodulation to generate the amplitude signal. Furthermore, the peak detection input circuit may comprise a diode configured to charge a capacitor to generate a voltage corresponding to the peak level. Advantageously, the diode can provide an additional protection from electrical or EMI noise.

Any of the above-disclosed implementations may further provide that the sample-and hold circuit is to receive an input signal dependent on the RF signal from one of the passive load or active circuit, and to generate the amplitude signal on the basis of the input signal when the input signal is above a threshold voltage.

Such an arrangement provides the further advantage that, regardless of the state of the driver, where the sample-and-hold circuit is effectively isolated from the driver, EMI may be further reduced since the sample-and-hold circuit can be effectively grounded from any input signals.

In implementations, the driver may be to drive the active circuit with a predetermined number of RF pulses during the period when the driver is enabled. A drive signal of the driver may be a series of pulses, for example a pulse-train such as a square wave or a sinusoidal wave. Generally, a pulse-train may have any duty-cycle, however around 50% is preferable to provide a good balance between power consumption and efficiency in resonating either the passive load or active circuit.

Generally, the sample-and-hold circuit will reach a peak level and/or steady state in response to a certain number of pulses. Thus, the number of pulses may be chosen to be sufficient to achieve this steady state/maximum capacity. After achieving this steady state, the driver may be disabled. The driver may therefore be actively driven only for a period of time sufficient for the sampling circuit to reach a steady state. Thus, power consumption may be substantially reduced, since the driving signal need not be continuously active, and/or the period of time over which the drive signal is enabled may be controlled precisely.

A sensor according to any above-described implementation may be configured wherein: the driver has a counter to count the RF pulses; and the drive enable circuit is to disable the driver in response to the count reaching the predetermined number. This may result in an inherent synchronicity, wherein counting the number of RF pulses results in a reproducible drive signal, and therefore a generally reproducible resonant response from either the active circuit or passive load. More accurate and/or reliable position and/or movement detections may then be obtained.

In implementations, the sample-and-hold circuit may be configured to be reset after the measurement and before a subsequent re-enabling of the driver by the drive enable circuit. This may allow a previously held peak level of the amplitude signal to be immediately reset, e.g. by discharge of a capacitive element, such that a further peak level can be sampled after a further enablement of the drive signal.

Alternatively, in embodiments without said reset function, the sample-and-hold circuit may allow a held peak level signal to decay (e.g. in an exponential fashion). The measurement circuit may perform a said detection during this decay period. In such an example, no reset switch is needed.

In implementations, the measurement circuit is to perform the measurement after elapse of a settling period during which the driver is disabled

A settling or waiting period may allow any residual noise or RF frequency from, e.g., the driver, active circuit or passive load, to dissipate before a detection by the measurement circuit. Thus, reliability and/or accuracy of the measurement may be improved due to the reduction in errors otherwise introduced by EMI noise.

According to a further aspect, there is provided a system comprising a multiplexer to enable a plurality of said resonant circuits to be driven at same or different times, preferably the resonant circuits to be driven sequentially, and to enable each measurement circuit to perform a said measuring during a period when driving of each of the active circuits by a driver is disabled by a said drive enable circuit. The system may be configured to enable the measurements by respective measurement circuits to occur simultaneously during the period when driving of each of the active circuits by a driver is disabled.

Thus, a plurality of measurements may be performed simultaneously when all of the active resonators are disabled. In embodiments, this may allow a fast scanning rate for multiple sensors controlled by a multiplexer. This may be beneficial in, e.g. a musical keyboard comprising e.g. 88 keys, and/or a computer keyboard comprising over 100 keys, where a rapid scan-rate is generally desired.

Further advantageously, because the sample-and-hold circuit may be configured to hold a peak level such that the driver need not be continuously active, multiple sensors may be driven in parallel, e.g., exactly in phase or only slightly out of phase. In other words, the detection by the measurement circuit for a plurality of sample-and-hold circuits can be obtained in the same measurement slot. This may contrast with measuring for one sensor per measurement cycle or time slot, e.g. driving an active circuit and subsequently performing a said detection by the measurement circuit one sensor at a time, which is generally less efficient.

The detection of relative position and/or movement can therefore be carried out simultaneously or sequentially for multiple sensors, each preferably during a period of time in which all driver(s) for the active circuits is/are disabled. The detection by the measurement circuit for multiple sensors may then be carried out within one measurement cycle, which may allow for a faster scanning rate in a multiplexing system.

According to a further related aspect, there is provided an apparatus that is a keyboard for a musical instrument, a computer keyboard, a computer touchpad, a foot pedal preferably for a musical instrument, or a drum, wherein the apparatus comprises at least one sensor according to an above-described sensor, or comprises an implementation of a system as described above, preferably wherein the musical instrument is an electric or acoustic piano, organ, guitar or drum.

In some implementations, the passive load may comprise a resonant circuit configured to resonate at the resonant frequency in response to the active circuit being driven by the driver. In such an implementation, the active circuit may comprise a resonant circuit configured to resonate at a frequency different to the resonant frequency.

Alternatively, in implementations, the passive load may comprise a conductive target.

In implementations having either of the above-described passive load, the active circuit may comprise a resonant circuit configured to resonate at the resonant frequency. For example, both the passive and active circuit may be tuned resonant circuits, e.g. inductive coils, optionally where each inductive coil comprise two primary smaller coils wired in series with opposing winding directions to form a figure-of-eight coil.

In implementations, the sample-and-hold circuit is coupled to an output of the active circuit, and configured to indicate the amplitude of said RF signal output from said active circuit. In other implementations, the sample-and-hold circuit may be coupled to an output of the passive load, and configured to indicate the amplitude of said RF signal output from said output of the passive load. In other words, an RF signal output of either the active circuit or passive load can be sampled and measured to determine a relative separation between the active circuit and passive load.

Arrangements where the passive load is a conductive target - such as a metal object which may lack a resonator coil - may be beneficial e.g. when only small changes in position need to be detected and/or where the target/passive load can be very close to the active circuit, for example in a computer touchpad. In such an example, said passive load is a conductive finger-pad which flexes in response to a touch and the amount of flex is measured by said sensor. Furthermore, a plurality of active sensors responsive to the said flexing of said conductive finger-pad allows the position of said touch to be determined by, for example, interpolation of the measured position output of each of said plurality of active sensors.

## BRIEF DESCRIPTION OF THE DRAWINGS

These and other aspects of the invention will now be further described, with reference to the accompanying drawings, in which:

Fig. 1 shows a block diagram of an inductive position sensing system as known in the art;
Fig. 2 shows an example electronic circuit for use as an active circuit of an inductive position sensor;
Fig. 3 shows an example electronic circuit for use as a passive target in an inductive sensing system;
Fig. 4 shows an example phase-sensitive-detector for detecting the output of an active circuit or passive load of an inductive position sensing system;
Fig. 5 shows an example amplitude-sensitive demodulator for detecting the output of an active circuit or passive load of an inductive position sensing system;
Fig. 6a shows an example PCB design, on an enlarged scale, for an embodiment of a tuned resonant circuit of an active circuit;
Fig. 6b shows an example PCB design, on an enlarged scale, for an embodiment of a tuned resonant circuit of a passive load;
Fig. 7 shows a cross section view of a key of a musical keyboard wherein the position of a key is determined using an example implementation of the system;
Fig. 8 illustrates an example timing diagram for a measurement process using a continuous drive signal, for a single position sensor with a circuit according to Fig. 5;
Fig. 9 shows a block diagram of an inductive position sensing system according to an embodiment;
Fig. 10 shows an example sample-and-hold electronic circuit;

Fig. 11 shows an example electronic circuit that combines amplitude-sensitive demodulation with a sample-and-hold function;

Fig. 12 shows a flowchart of a measurement process according to an embodiment;

Fig. 13 shows an example timing diagram of a measurement process of a single position sensor;

Fig. 14 shows an example timing diagram of a multiplexing scheme, corresponding to multiple measurements of a plurality of example sensors;

Fig. 15a shows an example voltage scan of a continuous drive signal and corresponding sensor response;

Fig. 15b shows an example voltage scan of a drive signal and sensor response according to a pulse burst embodiment.

Fig. 16a shows a further example voltage scan of a drive signal, sensor response, and timing signal according to an embodiment; and

Fig. 16b shows an enlarged view of the voltage scan of Fig. 16a.

DETAILED DESCRIPTION

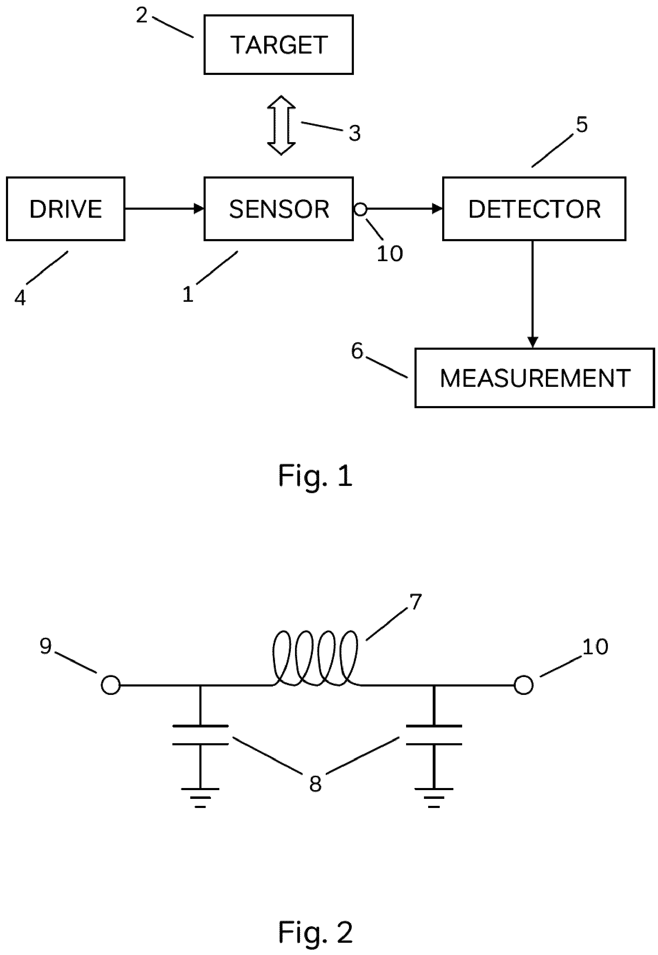

**Fig. 1** shows a block diagram of a sensing system which employs an inductive coil as a position / movement sensing element. The block diagram shows: an active circuit in the form of an inductive coil sensor 1 that has an output 10, where the output varies as the separation 3 between the coil sensor 1 and a passive load, i.e., target 2, varies. The sensor 1 is driven/excited by a driver 4 that produces a drive signal. The output 10 of the sensor 1 is processed by a detector 5 (otherwise referred to as a measurement circuit). Fig. 1 indicates that a measurement circuit 6 is used to generate a value representing or dependent on the separation between the sensor 1 and target 2. Generally, the position of one of the sensor 1 or target 2 may be measured relative to another. Alternatively or additionally, the relative movement and/or velocity of the sensor 1 and/or target 2 may be measured.

**Fig. 2** shows an active circuit in for the form of a sensor 1 for use in the sensing system of Fig. 1. The sensor 1 comprises: a sensor inductive coil 7; one or more capacitive elements 8 which form a resonant electronic circuit with said sensor inductive coil 7; a drive input 9 to which a suitable drive signal is applied; and an output 10 from which the output of said sensor is detected. The resonant electronic circuit may be tuned to a resonant frequency $f_R$ by choosing or tuning the capacitance of the capacitive elements 8 and/or the inductance of said sensor inductive coil 7. When a suitable time-varying drive signal, such as a sinusoid, pulse-train (such as a square-wave), with a frequency at, or close to, $f_R$ is applied to said drive input 9, the sensed output of said sensor is generally responsive to proximity of a suitable target 2.

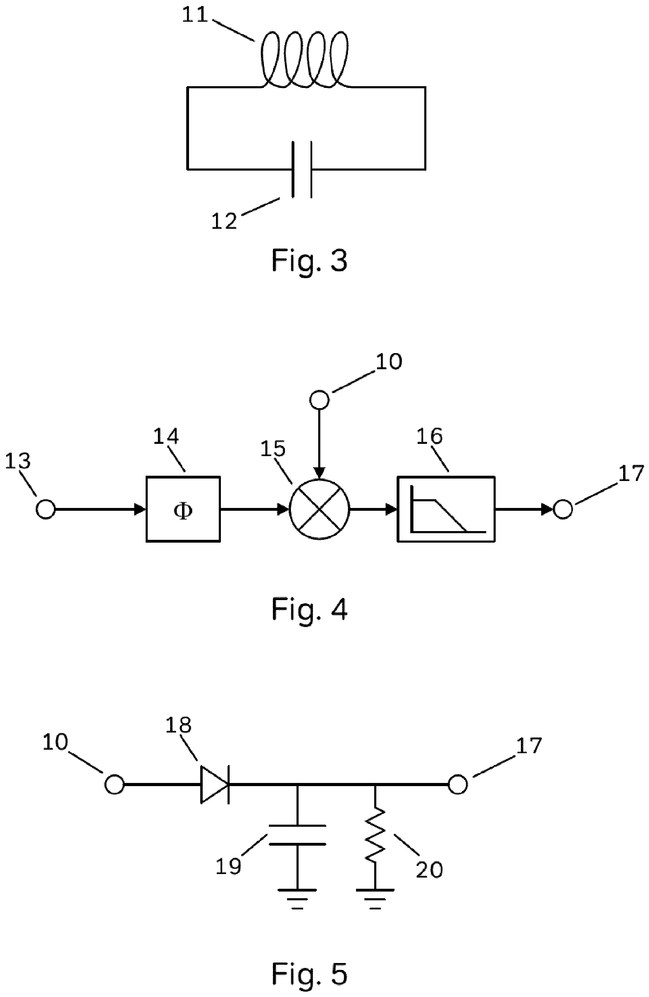

**Fig. 3** shows a tuned resonant circuit suitable for use as a target 2 in the sensing system of Fig. 1. Generally, a suitable target 2 may comprise or consist of any electrically conductive material, such as a metal. The target 2 may comprise a resonant circuit (optionally tuned) as shown. The conductive target does not necessarily comprise a resonant circuit. Merely for example, Fig. 3 shows a target inductive coil 11 connected to a target capacitive element 12 to form a resonant circuit with a resonant frequency which may be tuned to be equal to, or close to the resonant frequency, $f_R$, of the active circuit.

In some examples, the sensor output 10 is not suitable for direct measurement. In such cases, a detector 5, as shown in Fig. 1, may be used to process the sensor's 1 output to convert it into a form suitable for direct measurement.

**Fig. 4** shows one suitable configuration of such a detector, being a phase-sensitive detector comprising: a signal multiplier 15 connected to said sensor output 10; a reference input 13 connected to a reference signal synchronous to the sensor drive signal; a phase shifting element 14 to phase-shift said reference signal; a low-pass filter 16 to filter the output of said signal multiplier 15; and/or an output 17 from where said phase-sensitive detector output is obtained.

**Fig. 5** shows another example of a suitable detector configuration, being an amplitude-sensitive demodulator. This shows that the sensor output 10 is rectified by a diode 18 which forms a peak-hold circuit with a capacitive element 19 and a resistive element 20. The output of said peak-hold circuit is presented at an output 17. The time constant of the peak-hold circuit of Fig. 5 may be determined by the capacitance of the capacitive element 19 and the resistance of the resistive element 20, e.g. by $\tau$ = RC, where R is a resistance of resistive element 20, and C a capacitance of capacitive element 19.

Generally, however, the peak-hold circuit of Fig. 5 may be driven by a continuous drive signal to enable a detector to measure an output at output 17. Absent a continuous drive signal, it is still possible to measure a signal, however, such a signal from the output 17 would decay (e.g. exponentially) via the resistor 20. In examples, therefore, a high time constant (achieved e.g. by selecting a high resistance for the resistor 20) may be chosen to allow a signal to be read from the peak-hold circuit of Fig. 5, and this may enable a non-continuous drive signal to be used, thus advantageously saving power. In this regard, broadly speaking, the RC time constant decay time is preferably long relative to the measurement time, thus in embodiments resulting in reduced error caused by voltage drop-off following disablement of the drive signal. However, the RC decay time is preferably also sufficiently short relative to the cycle time, such that the held signal may substantially or completely decay before a subsequent measurement.

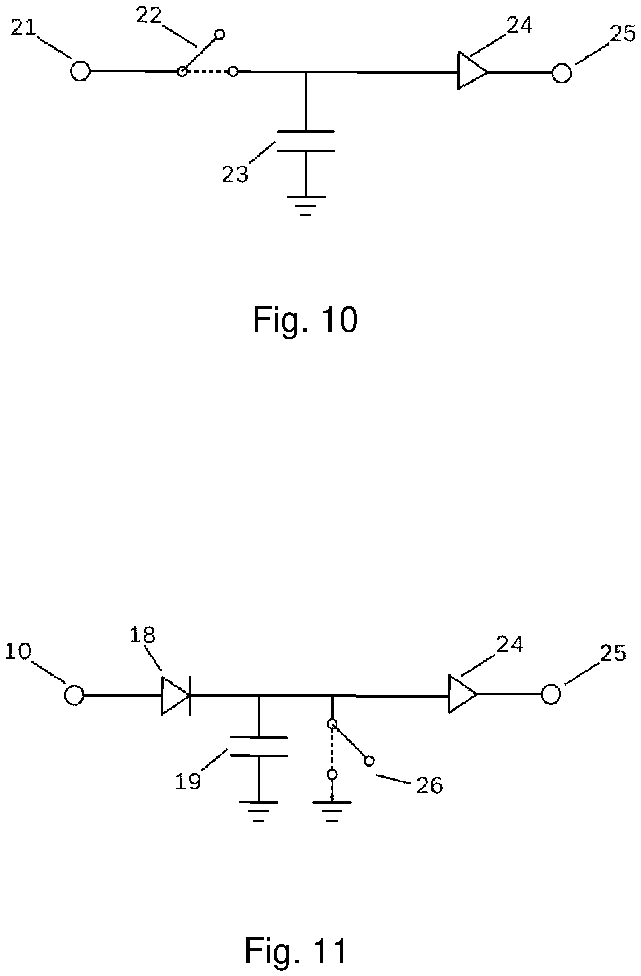

In this sense, the circuit of Fig. 5 can be seen as an approximation to a sample-and-hold circuit (e.g. as provided in Fig. 11), and may allow reduced power. Accuracy in measurement may generally be achieved by precisely controlling the time over which the drive signal is active, e.g. by counting the number of pulses.

The time constant of the low-pass filter 16 in Fig. 4 and/or the time constant of the peak-hold circuit in Fig. 5 may be chosen to be large enough to reduce (generally to a level acceptable for the application of the sensing system) the level of frequency components of the sensor drive signal, equal to or close to $f_R$, that appear in the said sensing system measurement 6 (as shown in Fig. 1). Such frequency components may otherwise introduce errors in the said measurement 6. The time constants are preferably small enough to be reactive to quick sensor movements, e.g. to allow sensing of rapid variations in sensor-to-target separation, according to the requirements of said application of the said sensing system. Therefore, when choosing said time constants, there may be a compromise between minimising measurement error by reducing the said level of frequency components of the sensor drive signal and maximising the speed of response of the sensing system measurement 6.

A sensing system embodiment comprising a detector of Fig. 4 or 5 may still be improved. For example, if the measurement is performed while the sensor drive signal is active, errors in the measurement may be introduced directly. Direct errors may arise because frequency components of the sensor drive signal not removed by filtering may cause unwanted variations in the measurement of the sensor. Similarly, a continuously active drive signal may cause indirect errors and/or reduce reliability, e.g. because the circuit voltage and current fluctuations resulting from said sensor drive signal are coupled into the measurement element, for example by an analogue-to-digital converter. In other words, a continuously active drive signal may cause unwanted additional electromagnetic interference (EMI).

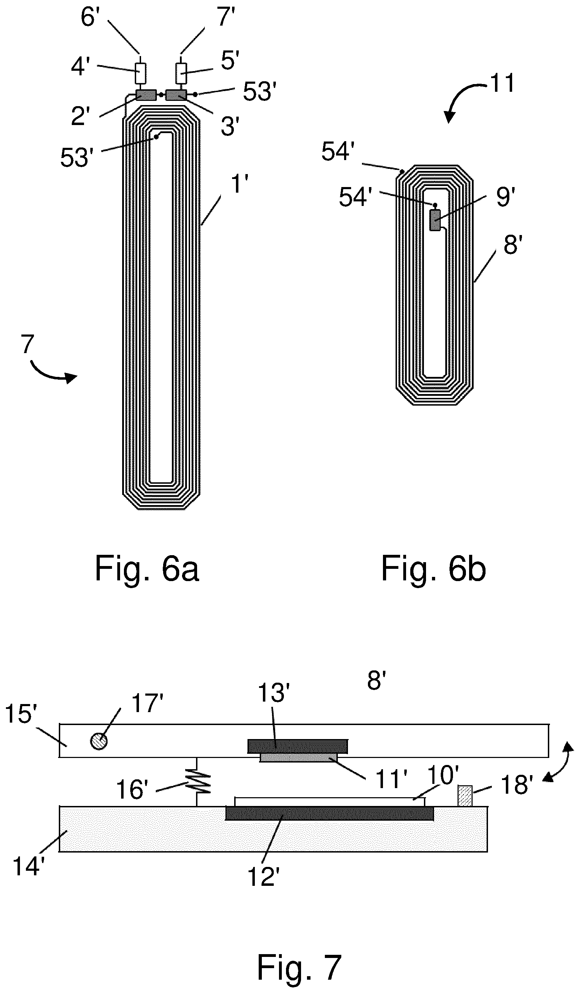

**Fig. 6** shows the induction coil components of an example sensor that may be used in conjunction with any of the measurement and/or detection circuits of the present disclosure. Figs. 6a and Fig. 6b show, respectively, an active tuned resonant circuit comprising a sensor inductive coil 7 to be driven by the sensor drive 4, and an example of a coil inductor 11 used for a target 2. Both circuits are a printed circuit design.

Referring to Fig. 6a, an active tuned resonant circuit may be formed on a printed circuit board comprising a single electrically conductive layer or a plurality of electrically conductive layers whereon: the coil 1' is formed of a continuous spiral track whereby electrical continuity of said track is maintained by electrical connection through connecting via 53' to a connecting wire or to another spiral track on another conductive layer or to a plurality of spiral tracks on a plurality of conductive layers of said printed circuit board. Capacitive elements 2' and 3' (e.g. corresponding to the capacitive elements 8 on Fig. 2) and resistive elements 4' and 5' are proximally located.

Connection points 6' and 7' are provided for drive electronics read-out electronics, respectfully.

Similarly, referring to Fig. 6b, a passive tuned resonant circuit (forming a target 2) may be formed on a printed circuit board comprising a single electrically conductive layer or a plurality of electrically conductive layers whereon: the coil 8' is formed of a continuous spiral track whereby electrical continuity of said track is maintained by electrical connection through connecting vias 54' to a connecting wire or to another spiral track on another conductive layer or to a plurality of spiral tracks on a plurality of conductive layers of said printed circuit board; and the capacitive element 9' is proximally located.

In other embodiments, the sensor inductive coil 7 of the active circuit may be formed from a plurality of electrically connected primary smaller coils wherein the winding direction of said primary smaller coils is chosen such that the sum of the electro-magnetic far field radiated from said primary smaller coils is substantially zero. A particularly suitable, but by way of non-limiting example, of said inductive coil 7 comprises two primary smaller coils wired in series with opposing winding directions to form a figure-of-eight coil. In such an arrangement the electro-magnetic far field radiated from the first half of said figure-of-eight coil may be equal in magnitude but with opposite polarity to the electro-magnetic far field radiated from the second half of said figure-of-eight coil, thus said electro-magnetic far field radiated from said figure-of-eight coil is substantially zero.

In such an arrangement, the target 2, being a passive tuned resonant circuit, may be ineffective unless the inductive coil of said passive tuned resonant circuit is primarily inductively coupled to only one half of the figure-of-eight coil of the active tuned resonant circuit. To maximise the output signal of the position sensor, it is preferable for said inductive coil of said passive tuned resonant circuit to be similarly formed of a figure-of-eight inductive coil, comprising two secondary smaller coils wired in series with opposing winding directions wherein each said secondary smaller coil is primarily inductively coupled to a different primary smaller coil of said figure-of-eight coil of said active circuit.

**Fig. 7** shows an example implementation of a resonant sensor in a musical keyboard. The key mechanism sensor comprises: a moveable top member 15' that is rotated about a pivot point 17' and which resists movement by means of a spring 16' or other mechanical linkage; a fixed bottom member 14'; a deformable end-stop 18' which limits movement of said top member; and a position sensor comprising an active tuned resonant circuit 10' inductively coupled to an electrically reactive element 11', henceforth referred to as the target, providing a signal which varies as the mutual separation of said active tuned resonant circuit and said target is varied, drive electronics connected to said active tuned resonant circuit and read-out electronics connected to said active tuned resonant circuit.

As shown in Fig. 1, generally, the target (e.g.

comprising a passively tuned resonant circuit) is not galvanically (e.g., not directly wired) coupled to the circuit, and only output of the active resonant sensor 1 may be measured, wherein the output changes based on the load on the active resonant sensor due to proximity of the sensor. However, it may be possible to measure an output of the passive load circuit based on how strongly it is driven by an actively driven resonator. In this case, the changing output of the active circuit may be irrelevant, since only the passive circuit may be measured. Generally, referring to Fig. 1, instead of the sensor output 10 being coupled to the detector 5, a target output could be directly coupled to the detector 5 (wherein the drive and sensor are conductively isolated from the rest of the system.)

Furthermore, in some examples, only the passive circuit has a tuned resonance, and the active circuit may not be tuned to a resonant frequency. In this regard, the active circuit may comprise an untuned transmitting coil, where the passive circuit comprises a receiving coil that is tuned to resonate at the frequency of the drive signal.

In summary, at least the following combination of circuits are possible for a resonant sensor for use in measurement schemes disclosed herein:

Output of **active circuit** is measured, in which:

i. sensor 1 is a resonant active circuit + target 2 is a conductive (metal) target;
ii. sensor 1 is a resonant active circuit + target 2 is a resonant passive circuit;

Output of **passive circuit** is measured, in which:

iii. sensor 1 is a resonant active circuit + target 2 is a resonant passive circuit;
iv. sensor 1 is a non-resonant (untuned) active circuit + target 2 is a resonant passive circuit.

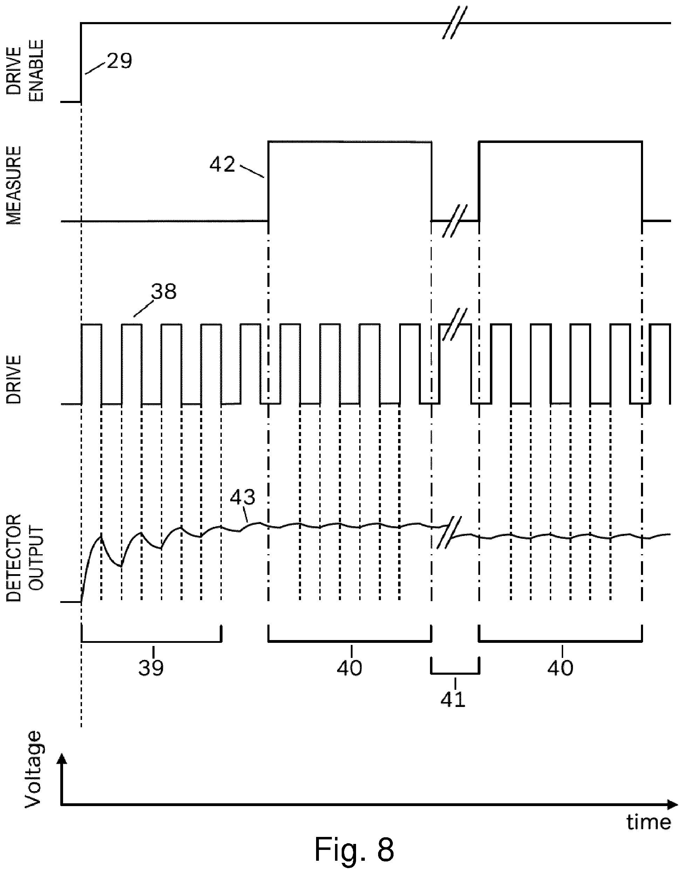

**Fig. 8** shows an example timing diagram to illustrate a method of driving and measuring a sensor that is compatible with the circuits of Fig. 4 or 5. As mentioned above, a continuous drive signal 38 may be used. The timing diagram shows that: the sensor drive signal 38 is enabled 29 and a continuous series of pulses is applied to the sensor; after an (optional) initial settling time 39 (e.g. to allow the signal 43 to stabilise), the detected output 43 from the said sensor approaches a value which represents the detected separation between a sensor and a target. This value of said detected output may contain frequency components of said drive signal 38 wherein the amplitude of said frequency components depends on the time constants of filtering that has been applied in the detector (not shown) producing said detected output. The drive signal shown is a square-wave, however any pulse-train (e.g. having a duty cycle other than 50%), and even a sinusoidal drive signal, may be suitable. Measurement 42 is done for a period of time 40 wherein said measurement may comprise additional filtering or processing to reduce the amplitude of said frequency components of said drive signal.

Consequently, therefore, there may be a trade-off between speed of measurements and the level of rejection of said frequency components of said drive signal. For example, a high time constant may reduce unwanted frequency components in the drive signal, however, may require a longer settling time. Optionally, a second measurement may be performed after a time period 41 has elapsed following the completion of a first measurement (thus, time period 41 may be zero).

Referring back to Fig. 5, although the mentioned direct and indirect errors may be reduced by employing a long time constant in the detector, this may reduce the response speed, which is undesirable e.g. where a high scan rate of the sensor is required. Furthermore, increasing the active time of said sensor drive signal (for instance, with a continuous signal) may increase the total electrical power required by said sensing system which is not desirable for a low-power sensing system. In addition, such increased power requirements may further increase the level of electro-magnetic emissions radiated by said sensing system at the fundamental frequency, and harmonic frequencies, of the said sensor drive signal, which is generally undesirable.

Therefore, it may be advantageous to further improve upon the peak-hold circuit of Fig. 5 and/or the measurement regime of Fig. 8 by providing a system with reduced power requirements and reduced EMI emissions.

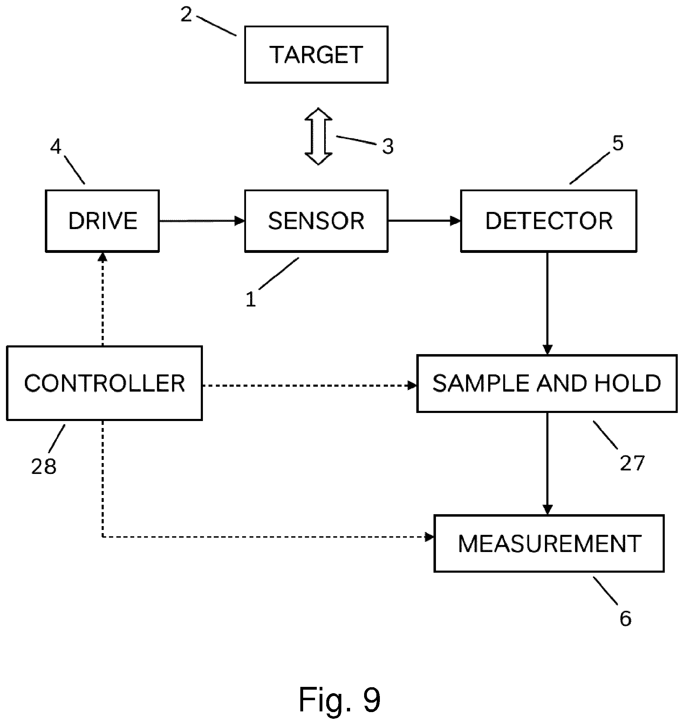

**Fig. 9** shows a block diagram of an improved sensing system. Relative to Fig. 1, a sample-and-hold circuit 27 has been interposed between the detector 5 and measurement circuit 6, and a controller 28 has been added to control each of: the sensor drive signal 4; the sample-and-hold circuit 27; and the measurement circuit 6. The peak-hold circuit of Fig. 5 is suitable for use as a sample-and-hold 27 circuit in some examples, e.g. where a large time constant is present.

**Fig. 10** shows a suitable sample-and-hold circuit 27 for use in an improved embodiment in the system of Fig. 9, comprising: an input 21, a sample/hold switch 22, a voltage storage capacitive element 23, an optional signal buffer 24 and/or an output 25. When operating in a sampling mode (e.g. sampling the signal presented at the said input 21) the switch 22 is closed such that the voltage storage capacitive element 23 charges or discharges towards a voltage level matching the (peak) voltage of said input 21. When said sample-and-hold circuit operates in the holding mode, the sample/hold switch 22 opens to allow the capacitive element 23 to maintain the sampled voltage to which it has been charged/-discharged to during sampling. Advantageously, such a circuit may maintain the sampled peak signal absent an active signal, thereby allowing for a non-continuous signal drive. This may allow for significant power savings and/or a reduction in EMI in general.

Preferably, to help ensure that the sampled voltage is maintained during the holding period, a high-impedance circuit path is provided at the active (non-grounded) side of said voltage storage capacitive element 23. This may be achieved by ensuring that the sample/hold switch has a high-impedance in the off-state, and optionally providing either that the output 25 is connected to a high-impedance measurement device, and/or by adding a signal buffer 24 to isolate the voltage storage capacitive element 23 from the impedance of the measurement device. In addition, a high impedance circuit path on the active side of the capacitive element 23 helps to prevent conducted electrical noise, and therefore helps to maintain the sampled voltage with increased stability.

**Fig. 11** shows a further improved sample-and-hold circuit for use with the system of Fig. 9, and shows a resettable peak detector. This has the advantage of performing amplitude-sensitive demodulation (e.g. as described with reference to Fig. 5) but without the requirement of a resistive element 20. The sample-and-hold circuit can therefore be seen as having an effective 'infinite' time constant. Thus, the sample-and-hold circuit of Fig. 11 has the advantage that no physical time constant is present, which may enable the sample-and-hold operation to be performed effectively while obviating a need in embodiments to compromise between sensor speed and removing unwanted frequency components in the drive signal. Surprisingly, therefore, potentially all three of an improved drive speed, reduced EMI emissions, and/or reduced power can be obtained from a resonant sensor comprising such a sample-and-hold circuit.

The resettable peak detector may comprise: a connection to the sensor output 10; a diode 18 which permits a voltage at said sensor output to charge a capacitive element 19; a reset switch 26 to discharge said capacitive element; and/or an output 25 connected to a measurement device. Optionally, a signal buffer 24 may be provided to isolate said capacitive element 19 from the impedance of said measurement device. Sampling may be performed when said reset switch 26 is open and when the sensor drive signal is active, which causes a signal to be present at the said sensor output 10. The capacitive element 19 charges when the voltage at said sensor output 10 is above the threshold voltage, $V_{th} = V_C + V_D$, where $V_C$ is the voltage stored on said capacitive element 19 and $V_D$ is the voltage drop across said diode 18. Holding is performed when the voltage at the said sensor input 10 is below the said threshold voltage, $V_{th}$, in which case the capacitive element 19 cannot discharge back through said diode 18. To perform a new sample-and-hold operation and measure a new sensor-target separation, the capacitive element 19 may be discharged by closing said reset switch 26, preferably when the sensor drive signal is inactive / not enabled.

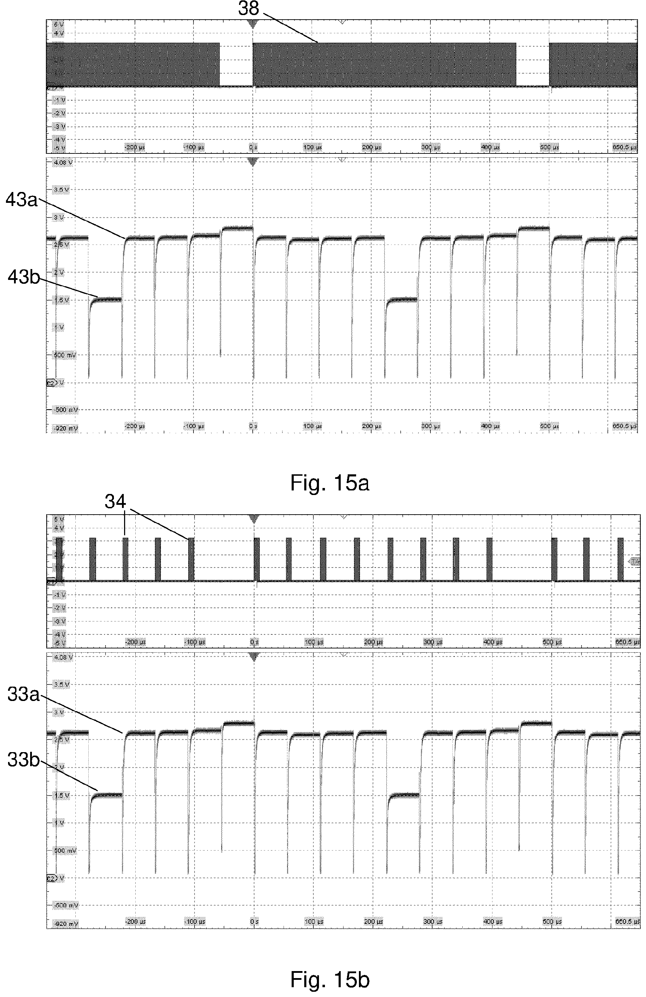

In preferred embodiments, and in contrast to Fig. 8, the sensor drive signal is non-continuous. For example, the sensor drive may be active for only a period of time, $t_{drive}$, for each measurement made by the sensing system. The $t_{drive}$ may be determined in advance: for example, an optimal value may be determined when said sensing system is designed, or during a calibration procedure that is performed from time-to-time. The period of $t_{drive}$ may be determined based on how long it takes a particular drive signal to drive a resonant sensor in rest position to a steady-state (e.g., see 33a of Fig. 15b).

In some embodiments, the sensor drive signal is formed of a series of pulses (e.g. a pulse-train, such as a square-wave) where the time between the start of successive pulses, $t_{period}$, set to be equal to, or close to, $\frac{1}{f_R}$ and the number of pulses in said series of pulses is an integer value. Thus, the number of said pulses in said series of pulses is $N_{drive}$, where $N_{drive} = \left\lfloor \dfrac{t_{drive}}{t_{period}} \right\rfloor$.

This applies to a pulse-train of any duty-cycle.

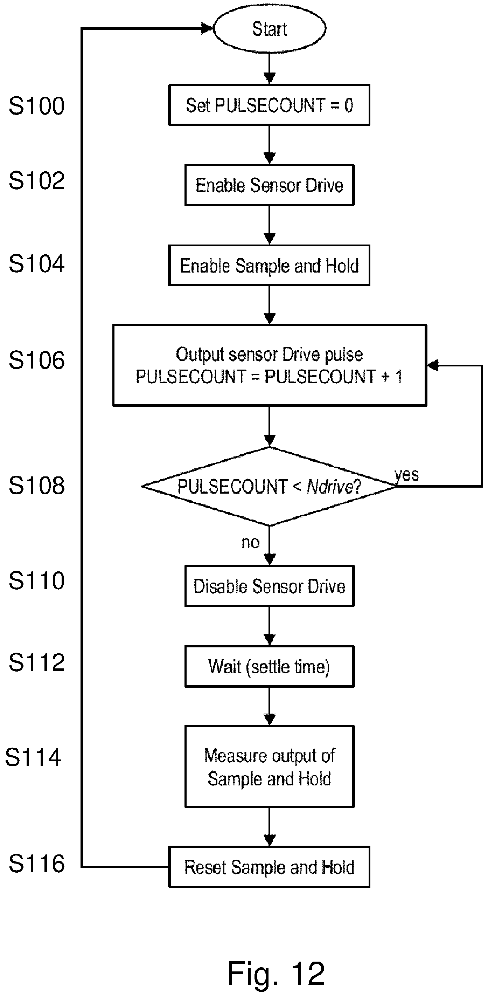

**Fig. 12** shows a flowchart of an example measurement process. It should be appreciated that the order of the steps of the flowchart is not limited the order shown. For example, the order of steps S100, S102, S104, can be rearranged, or preferably performed in parallel. At steps S106 and S108, the pulses are counted in order to ensure a reproducible output signal. Preferably, as described below, the phase of the pulse-train signal is synchronous with the activation S102 of the drive signal, such that an integer number of pulses are provided each time. The drive signal is disabled at step S110, in response to reaching a pre-determined number of pulse counts (e.g., corresponding to the time taken, $t_{drive}$, for outputting said number of pulses.) It should further be appreciated that step S112 in particular is optional, e.g., measurement could be performed immediately following disablement of the drive signal for increased scan rate. However, in some examples, it is preferable to allow a settling period where no drive signal is active in order to further reduce unwanted signals and/or EMI from the drive signal. A detection and/or measurement circuit measures the held peak signal at S114, after which the sample-and-hold circuit is reset at S116 (for example, by temporarily closing switch 26 in the circuit of Fig. 11).

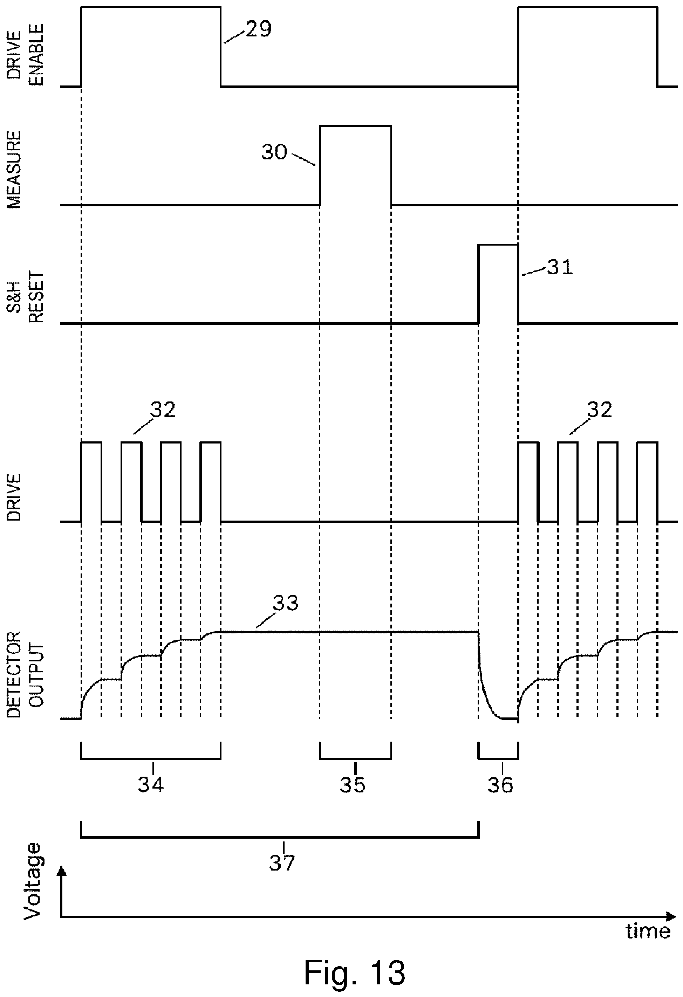

**Fig. 13** shows a timing diagram of an example measurement process, corresponding to the flowchart of Fig. 12. The process of Fig. 13 is initiated by enabling output of the sensor drive signal 29 and applying the signal 29 to the sensor as a series of pulses 32. The sample-and-hold circuit is operable to sample and hold the peak-level of the drive signal for a period of time 37, e.g. for the circuit shown in Fig. 11 the reset switch 26 is open to allow the capacitive element 19 to build charge. The detected output 33 from the sensor may approach a stable value during the active time, $t_{drive}$, of said series 32 of pulses, and is subsequently peak-held by said sample-and-hold circuit (as seen in the plateau of detector output 33). It will be understood that generally any oscillating drive signal is suitable (e.g. sinusoidal, pulse-train with asymmetric duty cycle, etc.), and that an inverted drive signal (relative to the pulses 32) is also possible. Generally, any oscillating signal that produces a resonance in an induction coil of a resonant sensor is suitable.

After the pre-determined number of said pulses, $N_{drive}$, has been applied to said sensor, the output of said sensor drive signal 29 is disabled (e.g. by a drive enable circuit, or digital controller) preferably in such a way that the output voltage of said sensor is below $V_{th}$ to ensure that any further fluctuations of the said output voltage of said sensor do not affect the voltage held by said sample-and-hold circuit. After an optional settling time (e.g. the interval between periods 34 and 35), a measurement 30 is initiated to measure the said voltage held by said sample-and-hold circuit, performed over a period of time 35. Finally, the said sample-and-hold circuit is reset 31 (for example, by closing a reset switch 26 in the case of the sample-and-hold circuit of Fig. 11) for a period of time 36. Thereafter, the sampling and measurement process as shown in Fig. 13 may repeat for subsequent measurements. The time interval between periods 35 and 36 is also optional, and is merely shown for clarity. For example, to provide an advantageously fast scan rate, the sample-and-hold circuit may be immediately reset following a measurement 35.

A circuit such as in Fig. 11 is preferable for use with the sampling and measurement process of Fig. 13. Advantageously, it can be seen in comparison to the measurement process of Fig. 8, that the held signal 33 of the sample-and-hold circuit is substantially more stable than the signal 43 of peak-hold circuit used in Fig. 8. This stability can be attributed to the lack of drive signal and/or the lack on an RC time constant used in Fig. 11, which may allow for substantially reduced EMI noise/errors in the detected output.

Furthermore, it is advantageous for the sensor drive signal 32 (e.g., the phase of a pulse-train signal) to be synchronous with the timing of the activation and deactivation 29 (e.g. the enabling and disabling of the drive signal by a drive enable circuit) of said sensor drive signal. In this manner, the form and phase of the sensor drive signal 32 is substantially similar each time the sensor is driven, preferably resulting in a reproducible output from said sensor and detector output 33, which in turn may yield measurements from the sensing system with high reproducibility and/or low error. Further, such a reproducible signal generally does not require averaging or filtering with a long time constant, allowing for faster sensor scan rates. In detail, for a given measurement performance, imposing this synchronicity allows $t_{drive}$ to be smaller than when the sensor drive signal is not synchronous with the timing of the activation/deactivation of the sensor drive signal. Reducing the length of $t_{drive}$, may advantageously reduce the electrical power requirements of the said sensing system, and/or allow said measurements from the said sensing system to be made more frequently. Thus, an embodiment may allow any one or more of: faster changes in position to be measured, faster scan rates for sensors, more accurate sensor velocity measurements, and/or a greater number of sensors to be effectively scanned in a multiplexing sensor system.

In embodiments, a time division multiplex system (e.g., controlled by a circuit or suitable digital controller) may be used to multiplex a plurality of active tuned resonant circuits to determine the relative position or motion of a plurality of sensors, according to an example implementation of the system. A musical keyboard comprising one sensor per key is an example implementation. In such an implementation, a subset of position sensors are enabled at any given time. Generally, multiplexing systems have the advantage of reducing cost, complexity, power consumption and electro-magnetic emissions where a large number of sensors are required.

Generally, driving a plurality of (adjacent) sensors simultaneously, or in rapid sequential succession, creates unwanted EMI and introduces measurement errors. For example, any given resonant sensor may be driven by the signal of an adjacent resonant sensor, which may create problems for accurately measuring the position of a given sensor. In this regard, multiplex systems may generally include one or more mitigation systems in order to reduce the amount of noise/EMI. Such mitigation methods may include, e.g.: synchronous demodulation of the output of position sensors to remove interference components; driving adjacent sensors at different resonant frequencies, designing the drive of the multiplex to avoid driving adjacent or nearby sensor simultaneously; and/or physically offsetting the position of adjacent sensors relative to one another. Such a system may add additional complexity to known multiplexing systems. Nevertheless, multiplex systems leave substantial room for improvement in terms of sensor speed: e.g. the time response of low-pass filters used in synchronous demodulation can limit the speed of response of said position sensors, which is undesirable.

Advantageously, sample-and-hold techniques and implementations of the present disclosure allow for faster multiplexing systems, e.g. where the driving and measurement of a plurality of sensor can effectively be performed in parallel, or much faster sequential succession, preferably without compromising on EMI emissions. For example, the circuit of Fig. 11, in particular the threshold voltage inherent in the diode 18, may provide for an effective electrical isolation between the sampling/detection circuits and any directly connected or adjacent drive signals/resonant sensors.

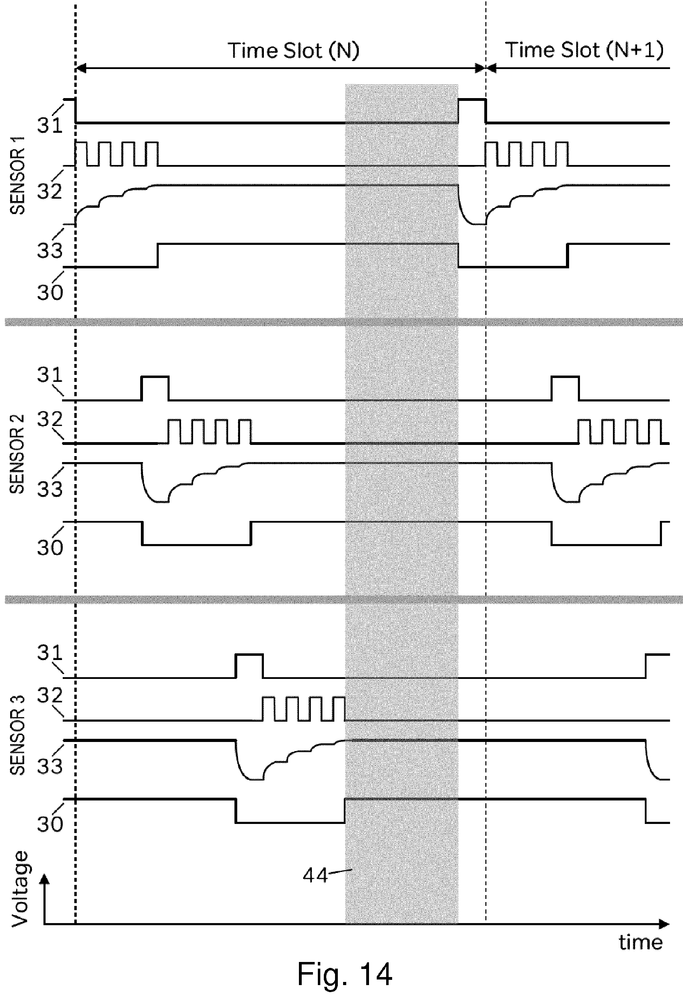

**Fig. 14** shows a timing diagram of a multiplexing scheme according to an embodiment, in which the measurement process of a single sensor (e.g., such as the process of Fig. 13) is applied to a plurality of sensors. Advantageously, in the improved multiplexing scheme shown, each sensor of said plurality of sensors is measured at least once in a given time slot, N. This contrasts with multiplexing systems that measure at most one sensor per time slot.

Within each said time slot: a drive signal 32 is applied as a series of pulses to each said sensor of the plurality of sensors; the detected output 33 of each said sensor is measured at least once within a valid time period 30; and the sample-and-hold circuit of the detector is reset 31. Preferably, the timing may be configured such that only one of the said drive signals for any of the said sensors is active at a given time. This may provide the advantage of reducing the peak power required by the measurement system and thus reducing the peak level of unwanted electro-magnetic radiation. Within each said time slot there may be a period of time 44 wherein it is possible to measure all of said sensors of the said plurality of sensors simultaneously, or sequentially. Optionally, as with S112 of Fig. 12, there may be an optional settling time between the last-enabled sensor drive and measurement. However, such a settling time generally may not be necessary, as the sequential drive signal enablement shown in Fig. 14 may provide an inherent settling time for at least sensor 1 and sensor 2 as shown.

It would nevertheless be possible to enable (and subsequently disable) the plurality of drive signals simultaneously, e.g. to provide an even faster multiplexing scan rate. Such a parallel driving scheme may still provide the advantage of reduced EMI, as the measurement period 44 occurs in the absence of any drive signal.

Fig. 15a shows an example of a voltage scan of a position sensor for a multiplexed keyboard in accordance with a continuous measurement process (e.g., as illustrated in Fig. 8). The continuous drive signal 38 is comprised of a pulse-train (individual pulses not visible). A multiplexing system drives the sensing of a group of eight position sensors, whose detector output signal 43 can be seen in the lower portion of the graph. The detector signal 43a corresponds to a key in rest position, and signal 43b corresponds to a depressed key (e.g., in this example where the target 2 and sensor 1 are closer together). The gap in the drive signal corresponds to a temperature correction step interposed between the cycle of eight multiplexing drives, where a direct current is provided that has no effect on the output of the position sensor. It is noted that such a temperature compensation step is optional (e.g., to account for variations in sensor temperature, which can affect the determined sensor output).

Fig. 15b shows a voltage scan for a position sensor similar to Fig. 15a, wherein the drive signal uses a 'burst' 34 of pulses, e.g. as described in relation to Fig. 13. Again, multiplexing of eight keys is shown, which a temperature stabilisation step. The detector output 33a shows a key at rest position, and 33b shows the detector output of a depressed key. Advantageously, the same signal response can be achieved by a drive signal which is enabled for a substantially reduced time period, thereby significantly lowering electrical power requirements.

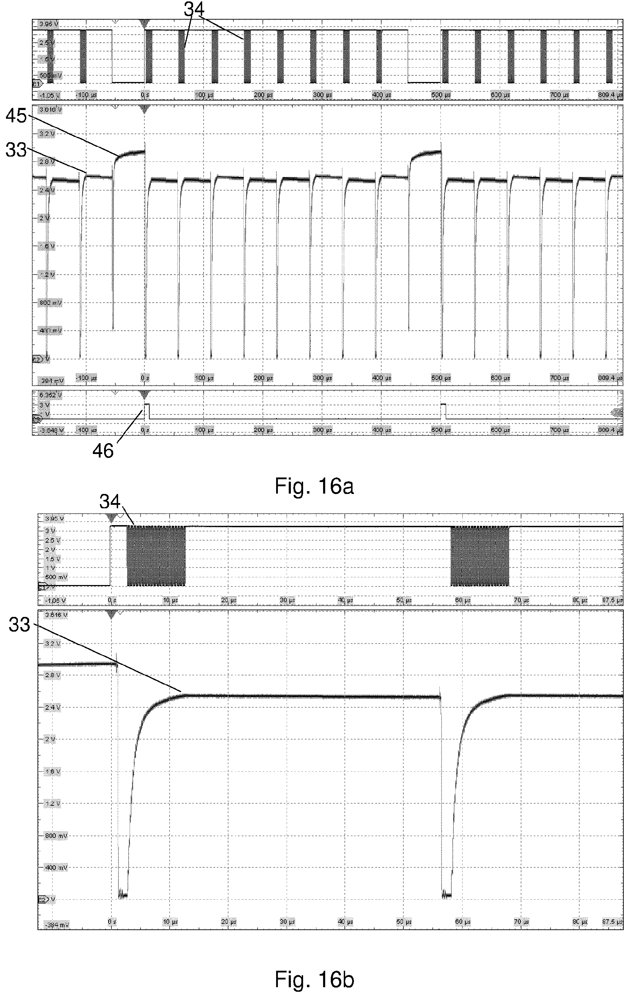

Fig. 16a shows a further example of a voltage scan for a position sensor for a multiplexed keyboard, wherein an inverted non-continuous drive signal 34 is used to drive the sensors. The temperature compensation step can be seen where the detector output signal 45 increases in response to a direct-current drive signal. Again, the burst of pulses forming the drive signal 34 are not visible. Furthermore, a timing signal 46 can be seen in the lower portion of the graph, used to control each multiple cycle. In detail, nine time slots are shown (eight of which are used to drive each of a group of eight sensors, and one to drive a temperature compensation step).

Fig. 16b shows an enlarged version of Fig. 16a, in which individual pulses of a pulses-train drive signal 34 can be seen.

The timing signal 46 is used to indicate the start of each measurement cycle of nine time slots. Regarding synchronisation between the drive signal and the measurement timing, therefore, it is advantageous to synchronise either the activation signal 46, and/or the timing of the drive enablement circuit, with the underlying frequency of the drive signal 34. This beneficially ensures that the start of a pulse-train is the same.

In some examples, simply counting the pulses would have inherent synchronisation provided that the first pulse starts the same each time (and not, e.g., partway through a pulse). In some example, e.g. where a free-running clock is used to control the periods of measurement cycle, a pulse counter may count the same total number of pulses each time, however, the alignment may not be uniform. For example, on one cycle, a quarter pulse may occur at the start, with a three-quarter pulse at the end; on another cycle we get half a pulse at the start and end. Each of these pulse-trains would drive a resonant sensor differently, and thus yield slightly different output. Therefore, is it preferably to align or match the clock and/or frequency of the drive signal with the clock and/or frequency of the timer signal 46, such that a reproducible set of pulses are provided each time. Generally speaking, in any scenario, it is advantageous for the start of the first pulse 32 relative to the drive signal 34 to be the same each time slot time.

It will be appreciated that the sensor disclosed herein, and the corresponding multiplexing system, can be applied to a variety of systems and products. For example: piano keyboard (fully electric, or integrated into acoustic piano); computer keyboard (e.g. a mechanical keyboard, wired or wireless); computer game controller; computer touchpad or electronic drawing tablet; electric drums; a pedal, for example a guitar pedal, one of the pedals on an electric piano, and organ pedal and the like. The low-power requirements of embodiments described herein are particularly useful for devices can rely on battery power, e.g. wireless devices such a computer keyboard or game controllers.

Generally, in related implementation, the above described techniques and sensors may be employed to, in effect, sense pressure, where a sensor comprises a deformable element, for example a block or layer of rubber, below and/or between of one or both of the passive resonant circuit and the active resonant circuit. Such an arrangement may be employed, for example, as a sensor for sensing aftertouch on a piano keyboard or on a computer keyboard. For example, after a key has already been depressed, an aftertouch (e.g. further key pressure) applied by a user can be sensed by a pressure sensor having said deformable rubber element.

In the case of an electric drum comprising a deformable drum head or pad mounted on a non-deformable bottom member, the passive load or active circuit of the sensor disclosed herein may be mounted on, or mechanically coupled to, said drum head or pad and the other of the passive load or active circuit of said sensor may be mounted on said bottom member. Thus, the position and velocity of said drum head or pad relative to said bottom member may be sensed. Furthermore, a plurality of such said sensors mounted on said drum allows the spatial position of the hit on the drum head or pad to be determined, for example, by interpolation or other signal processing.

No doubt many other effective alternatives will occur to the skilled person. It will be understood that the invention is not limited to the described embodiments and encompasses modifications apparent to those skilled in the art lying within the scope of the claims appended hereto.

**Claims**

1. A sensor (1) comprising:

   a resonant circuit comprising a passive load (2) and an active circuit, wherein at least one of the active circuit and passive load is tuned to resonate at a resonant frequency;
   a driver (4) to drive the active circuit to output an RF signal at the resonant frequency;
   a drive enable circuit (28) to generate a control signal to enable and disable the driver;
   a sample-and-hold circuit (27) for an amplitude signal indicating amplitude of an RF signal output from one of the passive load or active circuit, wherein the sample-and-hold circuit is to hold a peak level of the amplitude signal, the peak level being a peak level during a period when the driver is enabled; and
   a measurement circuit (6) to detect a relative position and/or movement between the passive load and active circuit based on the held peak level, the detection based on measuring the held peak level when the driver is disabled by the drive enable circuit.

2. The sensor of claim 1, wherein at least one of:

   (i) the measurement circuit is to detect a relative velocity between the passive load and the active circuit; and/or
   (ii) the measurement circuit is to perform the measurement after elapse of a settling period during which the driver is disabled.

3. The sensor of any preceding claim, wherein the sample-and-hold circuit comprises a peak detection input circuit, the peak detection input circuit configured to perform amplitude sensitive demodulation to generate the amplitude signal; and
   optionally wherein the peak detection input circuit comprises a diode (18) configured to charge a capacitor (19) to generate a voltage corresponding to the peak level.

4. The sensor of any one of claims 1 to 3, wherein at least one of:

   (i) the sample-and hold circuit is to receive an input signal dependent on the RF signal from one of the passive load or active circuit, and to generate the amplitude signal on the basis of the input signal when the input signal is above a threshold voltage; and/or
   (ii) the sample-and-hold circuit is configured to be reset after the measurement and before a subsequent re-enabling of the driver by the drive enable circuit.

5. The sensor of any preceding claim, wherein at least one of:

   (i) the driver is to drive the active circuit with a predetermined number of RF pulses during the period when the driver is enabled; and/or
   (ii) the driver has a counter to count the RF pulses; and

   the drive enable circuit is to disable the driver in response to the count reaching the predetermined number.

6. A system comprising a plurality of sensors of any preceding claim, the system comprising a multiplexer to enable a plurality of said resonant circuits to be driven at same or different times, preferably the resonant circuits to be driven sequentially, and to enable each measurement circuit to perform a said measuring during a period when driving of each of the active circuits by a driver is disabled by a said drive enable circuit.

7. The system of claim 6, configured to enable the measurements by respective measurement circuits to occur simultaneously during the period when driving of each of the active circuits by a driver is disabled.

8. An apparatus that is a keyboard for a musical instrument, a computer keyboard, a computer touchpad, a foot pedal preferably for a musical instrument, or a drum, wherein the apparatus comprises at least one sensor of any one of claims 1 - 5 or comprises the system of claim 6 or 7, preferably wherein the musical instrument is an electric or acoustic piano, organ, guitar or drum.

9. The apparatus of claim 8, wherein the apparatus is a keyboard for a musical instrument or computer, the keyboard comprising at least one key and a sensor according to any one of claims 1 - 5, wherein the key has a moveable part comprising either the passive load or active circuit, and wherein the keyboard has a reference part comprising the other of the passive load or active circuit.

10. A sensor of any of claims 1 to 5, or a system of claim 6 or 7, wherein either:

> (i) the passive load comprises a resonant circuit configured to resonate at the resonant frequency in response to the active circuit being driven by the driver; or
> (ii) the passive load comprises a conductive target.

11. A sensor of claim 10, wherein the active circuit comprises a resonant circuit configured to resonate at the resonant frequency.

12. A sensor of claim 10, wherein the passive load comprises the resonant circuit configured to resonate at the resonant frequency in response to the active circuit being driven by the driver, and wherein the active circuit comprises a resonant circuit configured to resonate at a frequency different to the resonant frequency.

13. A sensor of claim 10, wherein the sample-and-hold circuit is coupled to an output of the active circuit, and configured to indicate the amplitude of said RF signal output from said active circuit.

14. A sensor of claim 10, wherein the passive load comprises the resonant circuit configured to resonate at the resonant frequency in response to the active circuit being driven by the driver, and wherein the sample-and-hold circuit is coupled to an output of the passive load, and configured to indicate the amplitude of said RF signal output from said output of the passive load; and optionally wherein the active circuit comprises a resonant circuit configured to resonate at a frequency different to the resonant frequency.

15. A method of detecting position or movement, the method comprising:

> enabling (S102) a driver (4) to drive an active circuit with an RF signal having a frequency that is a resonant frequency of the active circuit or a passive load (2);
> sampling (S106), throughout a period when the driver is enabled, a signal indicating amplitude of an RF output from the active circuit or the passive load, and holding a peak level of the sampled indicating signal;
> continuing (S112) to hold the peak level of the indicating signal for at least part of a following period when the driver is disabled; and
> detecting (S114) a movement or position of one of the active circuit and passive load relative to the other of the active circuit and passive load, by measuring the held peak level during the part of the period when the driver is disabled.

**Patentansprüche**

1. Sensor (1), Folgendes umfassend:

> eine Resonanzschaltung, die eine passive Last (2) und eine aktive Schaltung umfasst, wobei mindestens eine von der aktiven Schaltung und der passiven Last so gestimmt ist, dass sie bei einer Resonanzfrequenz in Resonanz tritt;
> einen Treiber (4), um die aktive Schaltung so anzutreiben, dass sie ein HF-Signal an der Resonanzfrequenz ausgibt;
> eine Treiberaktivierungsschaltung (28), um ein Steuersignal zu erzeugen, um den Treiber zu aktivieren und zu deaktivieren;
> eine Abtast-Halte-Schaltung (27) für ein Amplitudensignal, das eine Amplitude eines HF-Signals angibt, das von einer von der passiven Last oder der aktiven Schaltung ausgegeben wird, wobei die Abtast-Halte-Schaltung zum Halten eines Spitzenpegels des Amplitudensignals dient, wobei der Spitzenpegel ein Spitzenpegel während eines Zeitraums ist, in dem der Treiber aktiviert ist; und
> eine Messschaltung (6) zum Erkennen einer relativen Position und/oder Bewegung zwischen der passiven Last und der aktiven Schaltung auf der Grundlage des gehaltenen Spitzenpegels, wobei die Erkennung auf dem Messen des gehaltenen Spitzenpegels basiert, wenn der Treiber durch die Treiberaktivierungsschaltung deaktiviert ist.

2. Sensor nach Anspruch 1, wobei mindestens eines von Folgendem gilt:

(i) die Messschaltung dient zum Erkennen einer relativen Geschwindigkeit zwischen der passiven Last und der aktiven Schaltung; und/oder

(ii) die Messschaltung dient zum Durchführen der Messung nach Ablauf eines Einschwingzeitraums, in dem der Treiber deaktiviert ist.

3. Sensor nach einem der vorhergehenden Ansprüche, wobei die Abtast-Halte-Schaltung eine Spitzenerkennungs-Eingabeschaltung umfasst, wobei die Spitzenerkennungs-Eingabeschaltung konfiguriert ist, um eine amplitudenempfindliche Demodulation durchzuführen, um das Amplitudensignal zu erzeugen; und

wahlweise wobei die Spitzenerkennungs-Eingabeschaltung eine Diode (18) umfasst, die konfiguriert ist, um einen Kondensator (19) aufzuladen, um eine Spannung zu erzeugen, die dem Spitzenpegel entspricht.

4. Sensor nach einem der Ansprüche 1 bis 3, wobei mindestens eines von Folgendem gilt:

(i) die Abtast-Halte-Schaltung dient zum Empfangen eines Eingabesignals, das von dem HF-Signal von einer von der passiven Last oder der aktiven Schaltung abhängt, und zum Erzeugen des Amplitudensignals auf der Grundlage des Eingabesignals, wenn das Eingabesignal über einer Schwellenspannung liegt; und/oder

(ii) die Abtast-Halte-Schaltung ist so konfiguriert, dass sie nach der Messung und vor einer darauffolgenden erneuten Aktivierung des Treibers durch die Treiberaktivierungsschaltung zurückgesetzt wird.

5. Sensor nach einem der vorhergehenden Ansprüche, wobei mindestens eines von Folgendem gilt:

(i) der Treiber dient zum Antreiben der aktiven Schaltung mit einer vorbestimmten Anzahl von HF-Impulsen während des Zeitraums, in dem der Treiber aktiviert ist; und/oder

(ii) der Treiber weist einen Zähler zum Zählen der HF-Impulse auf; und

die Treiberaktivierungsschaltung dient zum Deaktivieren des Treibers als Reaktion darauf, dass der Zähler die vorbestimmte Anzahl erreicht.

6. System, umfassend eine Vielzahl von Sensoren nach einem der vorhergehenden Ansprüche, wobei das System einen Multiplexer umfasst, um eine Vielzahl der Resonanzschaltungen so zu aktivieren, dass sie zu gleichen oder unterschiedlichen Zeiten angetrieben werden, vorzugsweise dass die Resonanzschaltungen sequentiell angetrieben werden, und um jede Messschaltung so zu aktivieren, dass sie eine Messung während eines Zeitraums durchführt, in dem das Antreiben jeder der aktiven Schaltungen durch einen Treiber durch eine Treiberaktivierungsschaltung deaktiviert ist.

7. System nach Anspruch 6, das konfiguriert ist, um die Messungen durch jeweilige Messschaltungen so zu aktivieren, dass sie gleichzeitig während des Zeitraums stattfinden, in dem das Antreiben jeder der aktiven Schaltungen durch einen Treiber deaktiviert ist.

8. Gerät, das eine Tastatur für ein Musikinstrument, eine Computertastatur, ein Computer-Touchpad, ein Fußpedal, vorzugsweise für ein Musikinstrument, oder eine Trommel ist, wobei das Gerät mindestens einen Sensor nach einem der Ansprüche 1 bis 5 umfasst oder das System nach Anspruch 6 oder 7 umfasst, vorzugsweise wobei das Musikinstrument ein elektrisches oder akustisches Klavier, eine Orgel, eine Gitarre oder eine Trommel ist.

9. Gerät nach Anspruch 8, wobei das Gerät eine Tastatur für ein Musikinstrument oder einen Computer ist, wobei die Tastatur mindestens eine Taste und einen Sensor nach einem der Ansprüche 1 bis 5 umfasst, wobei die Taste einen beweglichen Teil aufweist, der entweder die passive Last oder die aktive Schaltung umfasst, und wobei die Tastatur einen Referenzteil aufweist, der die andere der passiven Last oder der aktiven Schaltung umfasst.

10. Sensor nach einem der Ansprüche 1 bis 5, oder System nach Anspruch 6 oder 7, wobei entweder:

(i) die passive Last eine Resonanzschaltung umfasst, die konfiguriert ist, um als Reaktion darauf, dass die aktive Schaltung durch den Treiber angetrieben wird, bei der Resonanzfrequenz in Resonanz zu treten; oder

(ii) die passive Last ein leitendes Ziel umfasst.

11. Sensor nach Anspruch 10, wobei die aktive Schaltung eine Resonanzschaltung umfasst, die konfiguriert ist, um bei der Resonanzfrequenz in Resonanz zu treten.

12. Sensor nach Anspruch 10, wobei die passive Last die Resonanzschaltung umfasst, die konfiguriert ist, um als Reaktion darauf, dass die aktive Schaltung durch den Treiber angetrieben wird, bei der Resonanzfrequenz in Resonanz zu treten, und wobei die aktive Schaltung eine Resonanzschaltung umfasst, die konfiguriert ist, um bei einer Frequenz in Resonanz zu treten, die sich von der Resonanzfrequenz unterscheidet.

13. Sensor nach Anspruch 10, wobei die Abtast-Halte-Schaltung mit einer Ausgabe der aktiven Schaltung gekoppelt und zum Angeben der Amplitude des HF-Signals konfiguriert ist, das von der aktiven Schaltung ausgegeben wird.

14. Sensor nach Anspruch 10, wobei die passive Last die Resonanzschaltung umfasst, die konfiguriert ist, um als Reaktion darauf, dass die aktive Schaltung durch den Treiber angetrieben wird, bei der Resonanzfrequenz in Resonanz zu treten, und wobei die Abtast-Halte-Schaltung mit einer Ausgabe der passiven Last gekoppelt und so konfiguriert ist, dass sie die Amplitude des HF-Signals angibt, das von der Ausgabe der passiven Last ausgegeben wird; und wahlweise wobei die aktive Schaltung eine Resonanzschaltung umfasst, die konfiguriert ist, um bei einer Frequenz in Resonanz zu treten, die sich von der Resonanzfrequenz unterscheidet.

15. Verfahren zum Erkennen einer Position oder Bewegung, wobei das Verfahren Folgendes umfasst:

Aktivieren (S102) eines Treibers (4), um eine aktive Schaltung mit einem HF-Signal anzutreiben, das eine Frequenz aufweist, die eine Resonanzfrequenz der aktiven Schaltung oder einer passiven Last (2) ist;

während eines Zeitraums, in dem der Treiber aktiviert ist, Abtasten (S106) eines Signals, das eine Amplitude einer HF-Ausgabe der aktiven Schaltung oder der passiven Last angibt, und Halten eines Spitzenpegels des abgetasteten Angabesignals;

Fortsetzen (S112) des Haltens des Spitzenpegels des Angabesignals über mindestens einen Teil eines folgenden Zeitraums, in dem der Treiber deaktiviert ist; und

Erkennen (S114) einer Bewegung oder Position einer von der aktiven Schaltung und der passiven Last in Bezug auf die andere von der aktiven Schaltung und der passiven Last durch Messen des gehaltenen Spitzenpegels während des Teils des Zeitraums, in dem der Treiber deaktiviert ist.

**Revendications**

1. Capteur (1) comprenant :

un circuit de résonance comprenant une charge passive (2) et un circuit actif, dans lequel au moins l'un parmi le circuit actif et la charge passive est accordé pour résonner à une fréquence de résonance ;

un pilote (4) pour piloter le circuit actif pour émettre en sortie un signal RF à la fréquence de résonance ;

un circuit d'activation de pilote (28) pour générer un signal de commande pour activer et désactiver le pilote ;

un échantillonneur-bloqueur (27) pour un signal d'amplitude indiquant une amplitude d'un signal RF émis en sortie d'un parmi la charge passive ou le circuit actif, dans lequel l'échantillonneur-bloqueur est destiné à maintenir un niveau de crête du signal d'amplitude, le niveau de crête étant un niveau de crête pendant une période où le pilote est activé ; et

un circuit de mesure (6) pour détecter une position relative et/ou un mouvement relatif entre la charge passive et le circuit actif sur la base du niveau de crête maintenu, la détection étant basée sur la mesure du niveau de crête maintenu lorsque le pilote est désactivé par le circuit d'activation de pilote.

2. Capteur selon la revendication 1, dans lequel au moins un des suivants s'applique :

(i) le circuit de mesure est destiné à détecter une vitesse relative entre la charge passive et le circuit actif ; et/ou

(ii) le circuit de mesure est destiné à réaliser la mesure après un écoulement d'une période d'établissement pendant laquelle le pilote est désactivé.

3. Capteur selon l'une quelconque des revendications précédentes, dans lequel l'échantillonneur-bloqueur comprend un circuit d'entrée de détection de crête, le circuit d'entrée de détection de crête étant configuré pour réaliser une démodulation sensible à l'amplitude pour générer le signal d'amplitude ; et facultativement dans lequel le circuit d'entrée de détection de crête comprend une diode (18) configurée pour charger un condensateur (19) pour générer une tension correspondant au niveau de crête.

4. Capteur selon l'une quelconque des revendications 1 à 3, dans lequel au moins un des suivants s'applique :

(i) l'échantillonneur-bloqueur est destiné à recevoir un signal d'entrée dépendant du signal RF à partir d'un parmi la charge passive ou le circuit actif, et à générer le signal d'amplitude sur la base du signal d'entrée lorsque le signal d'entrée est supérieur à une tension de seuil ; et/ou

(ii) l'échantillonneur-bloqueur est configuré pour être réinitialisé après la mesure et avant une réactivation ultérieure du pilote par le circuit d'activation de pilote.

5. Capteur selon l'une quelconque des revendications précédentes, dans lequel au moins un des suivants s'applique :

(i) le pilote est destiné à piloter le circuit actif avec un nombre prédéterminé d'impulsions RF pendant la période où le pilote est activé ; et/ou
(ii) le pilote présente un compteur pour compter les impulsions RF ; et

le circuit d'activation de pilote est destiné à désactiver le pilote en réponse au compteur atteignant le nombre prédéterminé.

6. Système comprenant une pluralité de capteurs selon l'une quelconque des revendications précédentes, le système comprenant un multiplexeur pour activer une pluralité desdits circuits de résonance de manière à être pilotés aux mêmes moments ou à des moments différents, de préférence de manière à ce que les circuits de résonance sont pilotés séquentiellement, et pour activer chaque circuit de mesure de manière à réaliser une dite mesure pendant une période où le pilotage de chacun des circuits actifs par un pilote est désactivé par un dit circuit d'activation de pilotage.

7. Système selon la revendication 6, configuré pour activer les mesures par des circuits de mesure respectifs pour se produire simultanément pendant la période où le pilotage de chacun des circuits actifs par un pilote est désactivé.

8. Appareil qui est un clavier pour un instrument de musique, un clavier d'ordinateur, un pavé tactile d'ordinateur, une pédale à pied de préférence pour un instrument de musique, ou un tambour, dans lequel l'appareil comprend au moins un capteur selon l'une quelconque des revendications 1 à 5 ou comprend le système selon la revendication 6 ou 7, de préférence dans lequel l'instrument de musique est un piano électrique ou acoustique, un orgue, une guitare ou un tambour.

9. Appareil selon la revendication 8, où l'appareil est un clavier pour un instrument de musique ou un ordinateur, le clavier comprenant au moins une touche et un capteur selon l'une quelconque des revendications 1 à 5, dans lequel la touche présente une partie mobile comprenant soit la charge passive soit le circuit actif, et dans lequel le clavier présente une partie de référence comprenant l'autre parmi la charge passive ou le circuit actif.

10. Capteur selon l'une quelconque des revendications 1 à 5, ou système selon la revendication 6 ou 7, dans lequel soit :

(i) la charge passive comprend un circuit de résonance configuré pour résonner à la fréquence de résonance en réponse au fait que le circuit actif est piloté par le pilote ; soit
(ii) la charge passive comprend une cible conductrice.

11. Capteur selon la revendication 10, dans lequel le circuit actif comprend un circuit de résonance configuré pour résonner à la fréquence de résonance.

12. Capteur selon la revendication 10, dans lequel la charge passive comprend le circuit de résonance configuré pour résonner à la fréquence de résonance en réponse au fait que le circuit actif est piloté par le pilote, et dans lequel le circuit actif comprend un circuit de résonance configuré pour résonner à une fréquence différente de la fréquence de résonance.

13. Capteur selon la revendication 10, dans lequel l'échantillonneur-bloqueur est couplé à une sortie du circuit actif et configuré pour indiquer l'amplitude dudit signal RF émis en sortie dudit circuit actif.

14. Capteur selon la revendication 10, dans lequel la charge passive comprend le circuit de résonance configuré pour résonner à la fréquence de résonance en réponse au fait que le circuit actif est piloté par le pilote, et dans lequel l'échantillonneur-bloqueur est couplé à une sortie de la charge passive et configuré pour indiquer l'amplitude dudit signal RF émis en sortie de ladite sortie de la charge passive ; et

facultativement dans lequel le circuit actif comprend un circuit de résonance configuré pour résonner à une fréquence différente de la fréquence de résonance.

15. Procédé de détection de position ou de mouvement, le procédé comprenant :

l'activation (S102) d'un pilote (4) pour piloter un circuit actif avec un signal RF présentant une fréquence qui est une fréquence de résonance du circuit actif ou d'une charge passive (2) ;
l'échantillonnage (S106), sur une période où le pilote est activé, d'un signal indiquant une amplitude d'une sortie RF du circuit actif ou de la charge passive, et le maintien d'un niveau de crête du signal d'indication échantillonné ;
la poursuite (S112) du maintien du niveau de crête du signal d'indication pendant au moins une partie d'une période suivante lorsque le pilote est désactivé ; et
la détection (S114) d'un mouvement ou d'une position d'un parmi le circuit actif et la charge passive par rapport à l'autre parmi le circuit actif et la charge passive, en mesurant le niveau de

**EP 4 352 462 B1**

crête maintenu pendant la partie de la période où le pilote est désactivé.

Fig. 1

Fig. 2

Fig. 3

Fig. 4

Fig. 5

Fig. 6a

Fig. 6b

Fig. 7

Fig. 8

Fig. 9

Fig. 10

Fig. 11

S100 — Set PULSECOUNT = 0

S102 — Enable Sensor Drive

S104 — Enable Sample and Hold

S106 — Output sensor Drive pulse
PULSECOUNT = PULSECOUNT + 1

S108 — PULSECOUNT < *Ndrive*? — yes

no

S110 — Disable Sensor Drive

S112 — Wait (settle time)

S114 — Measure output of Sample and Hold

S116 — Reset Sample and Hold

Fig. 12

Fig. 13

Fig. 14

Fig. 15a

Fig. 15b

Fig. 16a

Fig. 16b

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- GB 2494230 A
- GB 2570533 A
- GB 1115184 A
- GB 2494183 A
- GB 1721448 A
- GB 2569578 A
- GB 1812826 A

- GB 1909213 A
- GB 2576610 A
- GB 1909214 A
- GB 2578346 A
- GB 2017797 A
- GB 1208162 A